Europäisches Patentamt

**European Patent Office** (11) Numéro de publication: **0 083 895**

Office européen des brevets **B1**

(12) **FASCICULE DE BREVET EUROPÉEN**

(45) Date de publication du fascicule du brevet:
18.03.87

(21) Numéro de dépôt: **82402401.2**

(22) Date de dépôt: **30.12.82**

(51) Int. Cl.⁴: **H 04 B 7/165,** H 03 C 7/02, H 03 D 9/06, G 01 S 7/02

(54) Circuit hyperfréquences remplissant les fonctions de modulateur, de mélangeur et de séparateur émission-réception et dispositifs utilisant un tel circuit.

(30) Priorité: **08.01.82 FR 8200194**

(43) Date de publication de la demande:
**20.07.83 Bulletin 83/29**

(45) Mention de la délivrance du brevet:
**18.03.87 Bulletin 87/12**

(84) Etats contractants désignés:
**BE CH DE FR GB IT LI NL SE**

(56) Documents cité:
**GB-A-1 605 163**
**US-A-4 163 232**
**US-A-4 301 432**

**PATENTS ABSTRACTS OF JAPAN, vol. 1, no. 20, 24 mars 1977, page 835(E76)**
**PATENTS ABSTRACTS OF JAPAN, vol. 2, no. 124, 18 octobre 1978, page 7350(E78)**
**PATENTS ABSTRACTS OF JAPAN, vol. 2, nr. 99, 17 août 1978, page 4875(E78)**
**PATENTS ABSTRACTS OF JAPAN, vol. 1, no. 94, 27 août 1977, page 2633(E77)**

(73) Titulaire: **Meyer, Sylvain, 49 Résidence Duroux, F-22300 Lannion (FR)**
Titulaire: **Goloubkoff, Michel, Penvern, F-22670 Pleumeur Bodou (FR)**
Titulaire: **Guena, Jean, 30 Cité Morgane, F-22560 Trebeurden (FR)**

(72) Inventeur: **Meyer, Sylvain, 49 Résidence Duroux, F-22300 Lannion (FR)**
Inventeur: **Goloubkoff, Michel, Penvern, F-22670 Pleumeur Bodou (FR)**
Inventeur: **Guena, Jean, 30 Cité Morgane, F-22560 Trebeurden (FR)**

(74) Mandataire: **Mongrédien, André, c/o BREVATOME 25, rue de Ponthieu, F-75008 Paris (FR)**

## Description

La présente invention a pour objet un circuit hyperfréquences remplissant les fonctions de modulateur, de melangeur et de séparateur émission-réception et des dispositifs utilisant un tel circuit.

Le domaine d'application de l'invention concerne les telecommunications et notamment la distribution par voie hertzienne de données, les systèmes de communication à accès multiple à répartition dans le temps, les réseaux de diffusion. interactifs (canal à fort débit pour la diffusion et à faible débit pour le retour), les moyens de transmission numérique ou analogique, etc...

Par hyperfréquences, on entend, de manière classique, le domaine qui s'étend au-delà d'environ 1GHz et qui se situe en général autour de 10 à 20 GHz.

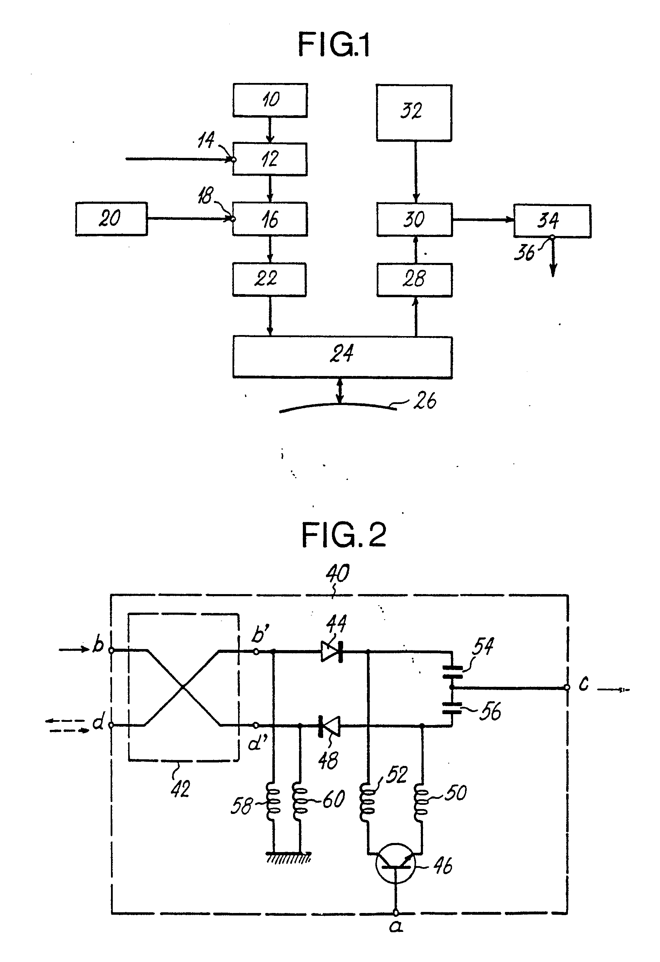

Un dispositif émetteur-récepteur classique travaillant en duplex (émission et réception simultanées) est représenté sur la figure 1. Un tel dispositif comprend une source d'émission hyperfréquences 10, un modulateur 12 recevant, sur une entrée 14, un train de données à transmettre, un mélangeur 16 relié au modulateur et recevant, sur une entrée 18, une onde délivrée par un oscillateur de transposition de fréquence 20, un amplificateur d'émission 22, un moyen 24 de séparation entre l'onde d'émission et l'onde de réception, une antenne 26 reliée à ce moyen, un amplificateur de reception 28, un mélangeur de réception 30 relié à l'amplificateur précédent et recevant une onde de réception, une source 32 engendrant cette onde, une chaîne d'amplification et de détection 34 travaillant à une fréquence intermédiaire égale à la différence des fréquences de réception et de celle de la source 32, cette chaîne délivrant sur une sortie 36 un train de données.

Une telle installation, qui est connue, fonctionne simultanement en émission et en réception. De ce fait, elle est relativement complexe puisqu'elle comprend deux sous-ensembles complets, l'un d'émission, l'autre de réception.

La présente invention a pour but de simplifier de tels dispositifs en réduisant le nombre de composants qu'ils comprennent. Ce but est atteint par l'utilisation d'un circuit qui peut remplir plusieurs des fonctions évoquées plus haut, a savoir la modulation, le mélange et la séparation émission-réception.

Le circuit de l'invention peut fonctionner en modulateur à l'émission et en mélangeur à la réception. Cela suppose naturellement que le dispositif qui l'utilise fonctionne alternativement en émission et en réception. Un tel mode de fonctionnement, dit "en alternat", est déjà connu dans le domaine de la transmission sur câble mais n'est pas utilisé en transmission hertzienne. Par ailleurs, le mode de fonctionnement en alternat est utilisé classiquement pour pouvoir travailler avec une seule ligne de transmission (en général sur paires symétriques). Dans l'invention, le but recherché est différent puisqu'il s'agit de réduire le nombre de composants hyperfréquences dans les stations d'émission-réception.

Le circuit de l'invention utilise essentiellement trois composants hyperfréquences, à savoir un coupleur directif et deux diodes ou plus généralement deux éléments à caractéristiques non linéaires. Il remplit trois types de fonctions différentes selon les signaux appliqués à ses accès.

Un tel circuit permet de réaliser des emetteurs-récepteurs pour des systèmes de transmission bidirectionnelle et des répéteurs pour ce type de système. Les avantages de ces dispositifs tiennent à leur simplicité, qui provient du nombre réduit de composants qu'ils emploient, donc à leur faible coût et à leur bonne fiabilité. On observera que plus la fréquence est élevée plus les composants sont chers. C'est donc dans le haut de gamme des hyperfréquences que l'invention trouve tout son intérêt. Mais naturellement, le bas de gamme n'est pas exclu pour autant.

On connaît déjà par le document JP-A-5 363 894 un circuit hyperfréquences remplissant les fonctions de modulateur, de mélangeur et de séparateur émission-réception. Ce circuit comprend un coupleur directif à 3 dB possédant un premier, un deuxième, un troisième et un quatrième accès, les premier et deuxième accès étant toujours adaptés mais le découplage entre ces accès étant important pour une valeur particulière d'adaptation des impédances aux troisième et quatrième accès, ce circuit comprenant en outre une première diode connectée au troisième accès à travers un premier transistor et un premier adaptateur, une deuxième diode connectée au quatrième accès à travers un second transistor et un deuxième adaptateur.

Le circuit de l'invention est de ce genre mais il est plus simple, notamment en ce qu'il ne comprend qu'un seul transistor de commande.

De façon plus précise, la présente invention a pour objet un circuit hyperfréquences du genre de ceux qui sont évoqués plus haut et qui est caractérisé par le fait que les deux diodes (44, 48) sont connectées en série à travers un premier et un second condensateurs, et par le fait qu'il comprend en outre :

- une branche connectée entre un point situé entre la première diode et le premier condensateur et un point situé entre le second condensateur et la seconde diode, cette branche comprenant une première inductance de réjection, un transistor et une seconde inductance de réjection, le transistor ayant une base reliée à un cinquième accès qui permet de commander l'état passant ou bloqué du transistor,

- un sixième accès relié à un point situé entre les deux condensateurs (54, 56),

- une première ligne comprenant au moins un élément quart d'onde reliant la terre à un point situé entre la première diode et le troisième accès,

- une seconde ligne comprenant au moins un élément quart d'onde reliant la terre à un point situé entre la seconde diode et le quatrième accès.

Les caractéristiques de l'invention apparaîtront mieux après la description qui suit, d'exemples de réalisation donnés à titre explicatif et nullement limitatif. Cette description se réfère à des dessins annexés qui font suite à

2

la figure 1 déjà décrite et sur lesquels:
- la figure 2 représente le schéma électrique équivalent du circuit de l'invention,
- la figure 3 représente le circuit de l'invention,
- la figure 4 représente un émetteur-récepteur utilisant le circuit de la figure précédente,
- la figure 5 est un chronogramme illustrant le fonctionnement du dispositif précédent,
- la figure 6 illustre un dispositif répéteur utilisant le circuit objet de l'invention.
- la figure 7 représente un dispositif de localisation de mobile,
- la figure 8 illustre les signaux utilisés dans le dispositif précédent,
- la figure 9 représente un dispositif de télémesure.

Le circuit représenté sur la figure 2 et referencé 40, comprend:
- un coupleur directif 42 à 3 db possédant une première paire d'accès b et d, et une seconde paire d'accès b' et d',
- une branche comprenant, en série, une première diode 44, un transistor 46 et une seconde diode 48 ; le transistor 46 possède une base reliée à un accès (a) de commande de son état (passant ou bloqué), un émetteur relié à travers une première inductance de réjection 50 à la diode 48 et un collecteur relié, par l'intermédiaire d'une seconde inductance de réjection 52 à l'autre diode 44. Cette branche est connectée entre les accès b' et d' du coupleur,
- deux condensateurs 54 et 56 reliés aux diodes 44 et 448 et possédant une armature commune reliée à un accès (c),
- deux lignes comportant un ou plusieurs éléments quarts d'onde représentées symboliquement par deux inductances 58 et 60 disposées entre la terre et les diodes 44 et 48.

Le fonctionnement de ce circuit est le suivant. Lorsqu'une impédance infinie est présente aux accès b' et d' du coupleur, une onde hyperfréquence appliquée à l'un des accès b ou d est alors totalement transmise vers l'autre. Lorsqu'une impédance de valeur particulière, dite impédance d'adaptation, est présente aux accès b' et d', une onde hyperfréquence appliquée aux accès b ou d de la première paire est alors transmise aux accès b' et d' par moitié. Si deux ondes sont appliquées aux accès b et d elles se trouvent mélangées à la sortie c du circuit. L'impédance d'adaptation peut être par exemple de 50 Ohms.

Entre ces deux états extrêmes de désadaptation et d'adaptation, selon que l'impédance aux bornes b' et d' est plus ou moins proche de l'impédance d'adaptation, une onde appliquée à l'accès b est plus ou moins transmise vers l'accès d, le coefficient de transmission étant compris entre 1 (cas de la désadaptation) et 0 (cas de l'adaptation).

Les diodes 44 et 48 ont un point à la terre en ce qui concerne la tension continue par le biais des conductances 58 et 60, qui sont en fait des lignes quart d'onde qui ramènent une impédance infinie à la fréquence utilisée mais qui ramènent le potentiel de terre en continu.

Lorsque le transistor 46 est bloqué, les diodes ne sont pas polarisées en continu et se comportent en circuit ouvert, et l'onde hyperfréquence est refléchie. Lorsque le transistor 46 est passant, l'énergie hyperfréquence appliquée sur l'accès b vient polariser les diodes dans le sens direct et l'onde hyperfréquence appliquée sur l'accès b et sur l'accès d traverse le coupleur, se mélangent sur les diodes 44 et 48. Au point c on recueille alors le mélange des deux ondes à travers les condensateurs 54 et 56.

Le circuit peut donc remplir deux fonctions différentes:

1) Si une onde hyperfréquence est appliqué sur l'accès b, on obtient sur l'accès d une onde transmise à condition que le transistor 46 soit bloqué. Cet état peut être obtenu en appliquant sur l'accès (a) relié a la base une tension appropriée, par exemple négative. On n'obtient aucune onde sur l'accès d si le transistor 46 est passant, c'est-à-dire un signal apte à débloquer le transistor appliqué sur l'accès (a) (par exemple une tension positive). Le circuit fonctionne donc en modulateur, l'onde appliquée sur l'accès b étant l'onde porteuse, le signal appliqué sur l'accès a étant l'information et l'onde délivrée par l'accès d étant l'onde modulée. Le modulation est du type tout ou rien si le transistor 46 est ou n'est pas bloqué. Les données pouvant être transmises par un tel modulateur sont alors du type numérique (suite de 0 et de 1). Il suffit de relier l'accès b à une source hyperfréquence, l'accès d à une antenne et l'accès a à la source de données. Mais le transistor 46 peut être plus ou moins passant ; la modulation est alors de type analogique.

2) Si une onde hyperfréquence est présente à la fois sur l'accès b et sur l'accès d, le circuit se comporte en mélangeur à la condition que le transistor 46 soit passant. L'accès c reçoit le mélange des deux ondes et peut être relié à un circuit de traitement en fréquence intermédiaire, fréquence qui est égale a la différence de fréquence des deux ondes reçues. L'accès b est alors relié à la source de réception et l'accès d à l'antenne. En définitive, c'est par l'accès a que le circuit se trouve être commandé.

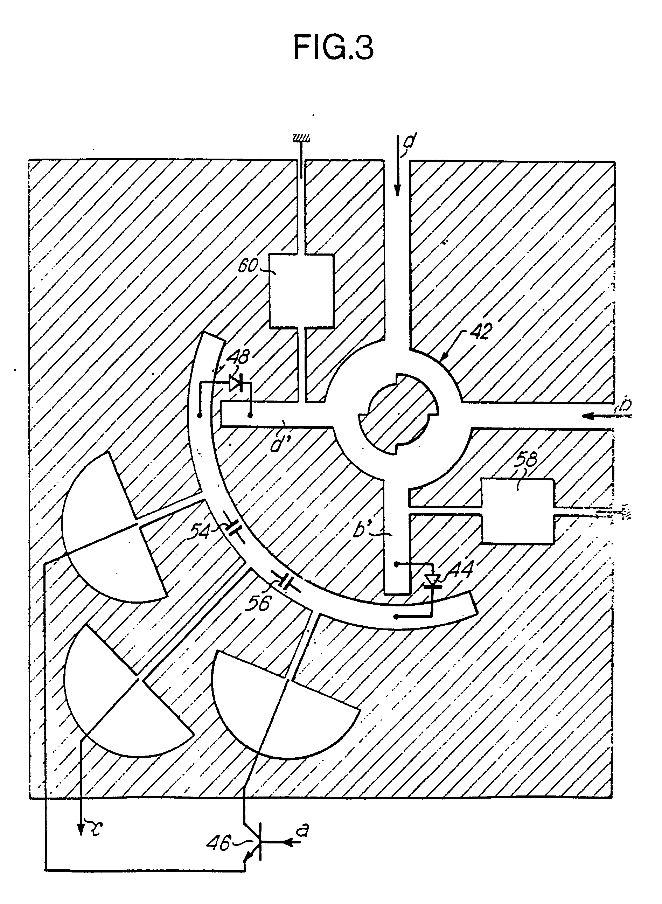

La figure 3 montre un schéma d'un mode de réalisation du circuit qui vient d'être décrit. Le circuit est représenté agrandi 8,5 fois, ce qui montre que ses dimensions sont faibles. Les éléments représentés portent les mêmes références que sur la figure 2.

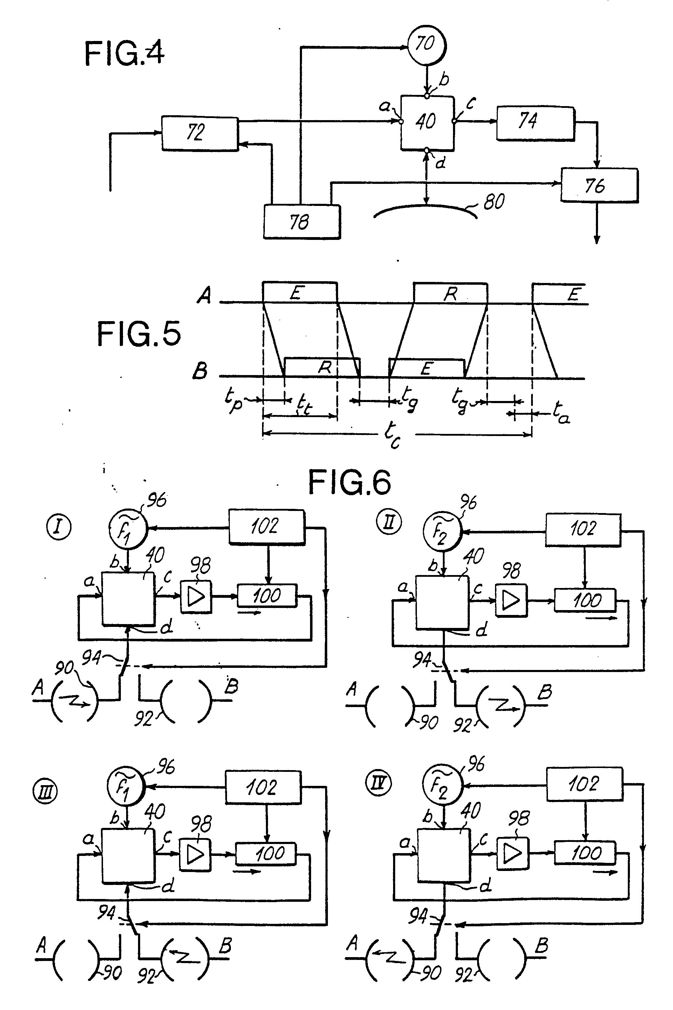

La figure 4 représente un dispositif émetteur-récepteur utilisant le circuit de l'invention. Ce dispositif comprend :
- un générateur hyperfréquence 70 apte à émettre alternativement une onde d'émission et une onde de réception,
- un premier circuit 72 de traitement de données apte à recevoir un train continu de données, par exemple numériques, et à délivrer ces mêmes données mais groupées par blocs,
- une chaîne d'amplification et de détection 74 travaillant à une fréquence intermédiaire égale à la différence de fréquence entre les ondes d'émission et de réception,

- un second circuit de traitement de données 76 relié à ladite chaîne et apte à recevoir des données numériques groupées par blocs et à délivrer les mêmes données sous forme d'un train continu,
- un circuit de synchronisation 78 commandant le premier et le second circuits de traitement de données 72, 74 et le générateur 70,
- une antenne 80.

Un tel dispositif nécessite en outre des moyens pour assurer alternativement une fonction de modulation de l'onde d'émission et de mélange d'une onde reçue avec l'onde de réception, et pour assurer une séparation entre l'onde d'émission dirigée vers l'antenne et l'onde reçue provenant de l'antenne. Selon l'invention ces moyens sont constitués par le circuit 40 qui a été décrit plus haut, dans lequel l'accès (a) est relié au premier circuit de traitement de données 72, l'accès b au générateur 70, l'accès c à la chaîne d'amplification et de détection 74 et l'accès d à l'antenne 80.

Le chronogramme de la figure 5 illustre le fonctionnement d'une liaison en alternat utilisant deux stations d'extrémité A et B, toutes deux identiques au dispositif de la figure 4. Sur ce schéma la signification des notations est la suivante:

E désigne la phase d'émission,

R la phase de réception,

$t_t$ la durée de la transmission d'un bloc de données,

$t_p$ le temps de propagation d'une extrémité à l'autre,

$t_g$ le temps de garde,

$t_a$ le temps d'attente,

$t_c$ le temps de cycle.

Le circuit 40 assure donc, dans un tel système, trois fonctions :

- modulation pendant les phases d'émission,
- mélange pendant les phases de réception,
- séparation émission-réception.

La figure 6 représente un dispositif répéteur comprenant :

- une première antenne 90,
- une seconde antenne 92,
- un aiguilleur 94 permettant de mettre en service, l'une quelconque de ces antennes,
- un générateur hyperfréquence 96 apte à émettre alternatiement une première onde hyperfréquence à une première fréquence $f_1$ et une seconde onde hyperfréquence à une seconde fréquence $f_2$,
- une chaîne d'amplification et de détection 98 travaillant à une fréquence intermédiaire égale à la différence de fréquence entre la première et la seconde ondes émises par le générateur,
- un circuit à retard 100 relié à ladit chaîne 98,
- un circuit de synchronisation 102 commandant le générateur 96, le circuit à retard 100 et l'aiguilleur 94,

Un tel répéteur doit comprendre encore des moyens pour assurer alternativement une fonction de modulation de la première onde et de mélange de la seconde onde avec une onde reçue provenant d'une des antennes et pour assurer une séparation entre l'onde d'émission et l'onde de réception. Selon l'invention ces moyens sont constitués par le circuit 40 qui a été décrit plus haut dans lequel l'accès (a) est relié au circuit à retard 100, l'accès (b) au générateur 96, l'accès (c) à la chaîne d'amplification et de détection 100, et l'accès (d) à l'aiguilleur 94.

La figure 6 représente les quatre phases possibles pour un tel répéteur (I, II, III, IV) ainsi que deux antennes A et B appartenant au répéteur précédent et au récepteur suivant. Le principe de fonctionnement est le suivant:

Phase I : le répéteur reçoit par son antenne 90 une onde modulée. L'onde reçue est dirigée par l'aiguilleur 94 vers l'accès d du circuit 40, lequel reçoit par ailleurs, du générateur 96, une onde de fréquence $f_1$. Le circuit 40 fonctionne en mélangeur. L'onde de mélange est extraite du circuit 40 par l'accès c et traitée dans le circuit 98. Les données numériques sont appliquées au circuit 100.

Phase II : le générateur 96 délivre une onde à la fréquence $f_2$; les données extraites du circuit 100 sont appliquées à l'entrée (a) du circuit 40, lequel fonctionne en modulateur ; l'aiguilleur 94 connecte l'antenne 92 qui réémet l'onde modulée vers le répéteur suivant.

Phase III : elle correspond à la phase I, les informations provenant cette fois de la voie de retour,

Phase IV : elle correspond à la phase II, les informations empruntant la voie de retour.

Une liaison a été expérimentée, qui utilise deux circuits conformes à la description qui précède. Les caractéristiques mesurées étaient les suivantes :.

fréquence : 22,15 GHz

débit : 2048 kbit/s

puissance rayonnée : 40 mW

gain du répéteur : 85 dB

facteur de bruit à la réception : 10 dB

dynamique de la partie linéaire de la courbe de modulation : supérieure à 20 dB

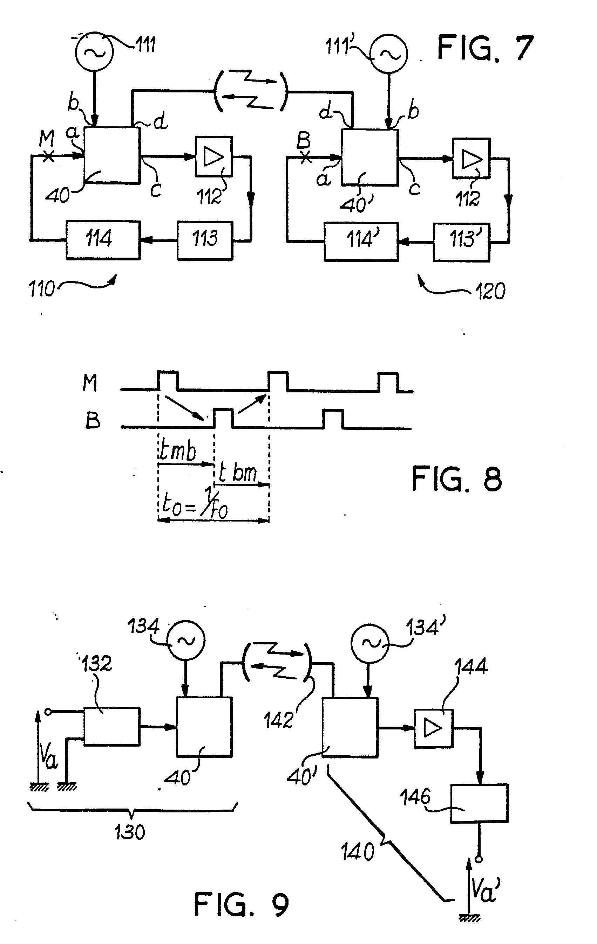

La figure 7 représente un dispositif de localisation de mobile utilisant le circuit hyperfréquences multifonction de l'invention.

L'utilisation d'un tel circuit à bord d'un mobile permet de mesurer l'azimut d'une balise ainsi que la distance à la balise.

Un seul relevé effectué sur une balise de localisation connue permet donc de repérer la position du mobile.

Pour ce qui est de la mesure de la distance, deux solutions sont possibles. La première illustrée sur la figure 7 met en oeuvre un mobile 110 et une balise 120. Le mobile comprend le circuit multifonction 40, un générateur 111, un amplificateur 112, un déclencheur 113, un monostable 114. La balise comprend les éléments analogues de mêmes références mais primées.

Par mesure de la fréquence de découpage fo modulant la tête du côté mobile, on en déduit la distance d'entre le mobile et la balise :

$$\frac{1}{fo} = \frac{2d}{c} \text{ donc } d = \frac{c}{2fo}$$

où c est la vitesse de la lumière.

En effet, les signaux en M et en B ont la forme représentée sur la figure 8 où tmb est le temps de propagation du mobile à la balise et tbm le temps de propagation de la balise au mobile. On a donc :

$$tmb + tbm = \frac{2d}{c} = \frac{1}{fo}$$

La deuxième solution utilise un circuit multifonction côté mobile avec modulation en tout ou rien à des fréquences allant de f1 à f2. La balise fonctionne en répondeur. La fréquence fo (f1 < fo < f2) pour laquelle l'énergie reçue par la tête hyperfréquence côté mobile est minimale correspond à un déphasage de 180° entre les impulsions émises et les impulsions reçues. On a :

$$\frac{1}{fo} = \frac{2d}{c}$$

donc:

$$d = \frac{c}{2fo}$$

Le procédé de modulation utilisé permet de réaliser des répéteurs bilatéraux très simples constitués comme sur la figure 7 avec une chaîne constituée d'un amplificateur, d'un déclencheur, d'un monostable inserée entre les accès c et a, l'antenne d'émission-réception étant reliée à l'accès d et le générateur à l'accès b.

Une autre application du circuit multifonction de l'invention consiste dans la réalisation d'un système de télémesure.

La valeur Va d'une tension analogique représentant une grandeur à mesurer est à transmettre à distance. Le principe de la liaison est donné par le schéma de la figure 9.

Côté mesure 130, le circuit comprend un oscillateur commandé en tension 132 (V.C.O.) recevant la tension Va à transmettre, le circuit 40 de l'invention, un générateur 134 et une antenne 136. Côté réception 140, on trouve une antenne 142, un circuit 40' conforme à l'invention, un générateur 134', un amplificateur 144 et une boucle à verrouillage de phase 146 dont la sortie délivre une tension Va'.

Le fonctionnement de ce circuit est le suivant. La fréquence de modulation utilisée côté mesure 130 est pilotée par la valeur à mesurer Va. Côté distant 140, la tête hyperfréquence est maintenue en réception en temps normal. La boucle à verrouillage de phase 146 est asservie à la fréquence de modulation reçue, ce qui restitue une tension Va' égale à la tension Va.

En utilisant le circuit multifonction 40' côté distant 140 en émission, on peut envoyer une commande en retour vers l'extrémité de mesure 130, par exemple pour commuter l'oscillateur 132 sur une autre grandeur à mesurer.

L'un des intérêts des systèmes décrits est qu'ils peuvent être rendus peu volumineux, vu le nombre réduit de composants qu'ils mettent en jeu, et vu la compacité du circuit hyperfréquence multifonction utilisé et d'une éventuelle antenne imprimée associée.

## Revendications

1. Circuit hyperfréquences remplissant les fonctions de modulateur, de mélangeur et de séparateur emission-réception, comprenant un coupleur directif (42) à 3 dB possédant un premier, un deuxième, un troisième et un quatrième accès (b, d, b', d'), les premier et deuxième accès étant toujours adaptés mais le découplage entre ces accésétant important pour une valeur particulière d'adaptation des impédances aux troisième et quatrième accès, ce circuit comprenant en outre une première diode (44) connectée au troisième accès (b') et une deuxième diode (48) connectée au quatrième accès (d'), ce circuit étant caractérisé par le fait que les deux diodes (44, 48) sont connectées en série à travers un premier et un second condensateurs (54, 56), et par le fait qu'il comprend en outre :

- une branche connectée entre un point situé entre la première diode (44) et le premier condensateur (54) et un point situé entre le second condensateur (56) et la seconde diode (48), cette branche comprenant une première inductance de réjection (52), un transistor (46) et une seconde inductance de réjection (50), le transistor (46) ayant une base reliée à un cinquième accès (a) qui permet de commander l'état passant ou bloqué du transistor,

- un sixième accès (c) relié à un point situé entre les deux condensateurs (54, 56),

- une première ligne comprenant au moins un élément quart d'onde (58) reliant la terre à un point situé entre la première diode (44) et le troisième accès (b'),

- une seconde ligne comprenant au moins un élément quart d'onde (60) reliant la terre à un point situé entre la seconde diode (48) et le quatrième accès (d').

2. Dispositif émetteur-récepteur pour transmission bidirectionnelle, comprenant :

- un générateur hyperfréquence (70) apte à émettre alternativement une onde d'émission et une onde de réception,

- un premier circuit de traitement de données (72) apte à recevoir un train continu de données et à délivrer ces mêmes données mais groupées par blocs,

- une chaîne d'amplification et de détection (74) travaillant à une fréquence intermédiaire égale à la différence de fréquence entre les ondes d'émission et de réception,

- un second circuit de traitement de données (76) relié à ladite chaîne (74) et apte à recevoir des données groupées par blocs et à délivrer les mêmes données sous forme d'un train continu,

- un circuit de synchronisation (78) commandant le premier et le second circuits de traitement de données (72, 74) et le générateur (70),

- une antenne 80,

- et des moyens pour assurer alternativement une fonction de modulation de l'onde d'émission et de mélange d'une onde reçue avec l'onde de réception, et pour assurer une séparation entre l'onde d'émission dirigée vers l'antenne et l'onde reçue provenant de l'antenne, caractérisé en ce que ces moyens sont constitués par le circuit (40) de la revendication 1, dans lequel l'accès (a) est relié au premier circuit de traitement de données (72), l'accès (b) est relié au générateur (70), l'accès (c) est relié à la chaîne d'amplification (74) et l'accès (d) à l'antenne (80).

3. Dispositif selon la revendication 2, caractérisé en ce que les données sont de type numérique.

4. Dispositif répéteur comprenant :

- une première antenne (90),

- une seconde antenne (92),

- un aiguilleur (94) permettant de mettre en service l'une quelconque de la première et de la seconde antennes,

- un générateur hyperfréquences (96) apte à émettre alternativement une première onde hyperfréquence à une première fréquence et une seconde onde hyperfréquence à une seconde fréquence,

- une chaîne d'amplification et de détection (98) travaillant à une fréquence intermédiaire égale à la différence de fréquence entre la première et le séconde ondes émises par le genératéur,

- un circuit à retard (100) relié à ladite chaîne (98),

- un circuit de synchronisation (102) commandant le générateur (96), le circuit à retard (100) et l'aiguilleur (94),

- des moyens pour assurer alternativement une fonction de modulation de le première onde et de mélange de le seconde onde avec une onde reçue provenant de l'une des antennes et pour assurer une séparation entre l'onde d'émission et l'onde de réception,

caractérisé en ce que ces moyene sont constitué par le circuit (40) de la revendication 1, dans lequel l'accès (a) est relié au circuit à retard (100), l'accès (b) est relié au générateur (96), l'accès (c) est relié à le chaîne d'amplification et de détection (98), et l'accès (d) à l'aiguilleur (94).

5. Dispositif de localisation d'un mobile par rapport à une balise, caractérisé en ce que, à bord du mobile (110) on trouve le circuit (40) selon la revendication 1, l'accès b étant relié à un générateur (111) l'accès c à un amplificateur (112) relié à un déclencheur (113) relié à un monostable (114) rebouclé sur l'accès a, l'accès d étant relié à une antenne, la balise comprenant les mêmes éléments.

6. Dispositif de localisation d'un mobile par rapport à une balise, caractérisé en ce que à bord du mobile on trouve le circuit (40) selon la revendication 1, et des moyens de modulation en tout ou rien, la balise comprenant elle aussi ledit circuit et fonctionnant en répondeur.

7. Dispositif répéteur caractérisé en ce qu'il comprend le circuit selon la revendication 1, avec, insérée entre les accès c et a une chaîne comprenant un amplificateur, un déclencheur, un monostable, et en ce qu'il comprend un générateur relié à l'accès b et une antenne d'émission-réception reliée à l'accès d.

8. Dispositif de télémesure, caractérisé en ce qu'il comprend, côté mesure, un circuit (40) selon la revendication 1, l'accès a étant relié à un oscillateur commandé en tension (132) recevant la grandeur à mesurer, l'accès b à un générateur, l'accès d à une antenne (136) et, côté réception, un circuit (40') selon la revendication 1, l'accès d étant relié à une antenne (142), l'accès b à un générateur (134'), l'accès c à un amplificateur (144) suivi d'une boucle à verrouillage de phase (146) dont la sortie délivre une grandeur (Va') correspondant à la grandeur mesurée (Va).

**Patentansprüche**

1. Als Modulator, Mischer und Sender-Empfangsumschalter arbeitende Mikrowellenschaltung mit einem Drei-dB-Richtkoppler (42) mit einem ersten, einem zweiten, einem dritten und einem vierten Zugang (b, d, b', d'), wobei der erste und der zweite Zugang stets angepaßt sind, aber die Entkopplung zwischen diesen Zugängen für einen besonderen Anpassungswert der Impedanzen beim dritten und vierten Zugang groß ist, wobei diese Schaltung eine erste, mit dem dritten Zugang (b') verbundene Diode (44) und eine zweite, mit dem vierten Zugang (d') verbundene Diode (45) aufweist, dadurch gekennzeichnet, daß die zwei Dioden (44, 48) in Reihe über einen ersten und einen zweiten Kondensator (54, 56) verbunden sind und daß sie ferner umfaßt:
- einen Zweig, der zwischen einem sich zwischen der ersten Diode (44) und dem ersten Kondensator (54) befindenden Punkt und einem sich zwischen dem zweiten Kondensator (56) und der zweiten Diode (48) befindenden Punkt verbunden ist und eine erste Sperrinduktivität (52), einen Transistor (46) und eine zweite Sperrinduktivität (50) aufweist, wobei die Basis des Transistors (46) mit einem fünften Zugang (a) verbunden ist, der ermöglicht, den durchgeschalteten oder gesperrten Zustand des Transistors zu steuern,
- einen sechsten Zugang (c), der mit einem sich zwischen den zwei Kondensatoren (54, 56) befindenden Punkt verbunden ist,
- eine erste Leitung, die wenigstens ein Viertel-Wellenlängenelement (58) aufweist, welches die Erde mit einem sich zwischen der ersten Diode (44) und dem dritten Zugang (b') befindenden Punkt verbindet,
- eine zweite Leitung, die wenigstens ein Viertel-Wellenlängenelement (60) aufweist, welches die Erde mit einem sich zwischen der zweiten Diode (45) und dem vierten Zugang (d') befindenden Funkt verbindet.

2. Sender-Empfängervorrichtung zur Zweirichtungsübertragung mit:
- einem Mikrowellengenerator (70), der abwechselnd eine Senderwelle und eine Empfangswelle aussenden kann,
- einer ersten Datenverarbeitungsschaltung (72), die einen durchgehenden Datenzug empfangen und die gleichen Daten aber zu Blöcken gruppiert abgeben kann,
- einer Verstärker- und Erfassungskette (74), die auf einer Zwischenfrequenz arbeitet, die gleich dem Frequenzunterschied zwischen den Sende- und Empfangswellen ist,
- einer zweiten Datenverarbeitungsschaltung (76), die mit der Kette (74) verbunden ist und die zu Blöcken gruppierten Daten empfangen und die gleichen Daten in der Form eines kontinuierlichen Zuges abgeben kann,
- einer Synchronisierungsschaltungt (75), die die erste und zweite Datenverarbeitungsschaltung (72, 74) und den Generator (70) steuert,
- einer Antenne (80)
- und Mitteln, um abwechselnd eine Modulationsfunktion bei der Sendewelle und eine Mischfunktion einer erhaltenen Welle mit der Empfangswelle sicher zu stellen und um eine Trennung zwischen der zu der Antenne gerichteten Sendewelle und der über die Antenne empfangenen Welle sicher zu stellen, dadurch gekennzeichnet, daß diese Mittel von der Schaltung (40) gemäß Anspruch 1 gebildet sind, bei der der Zugang (a) mit der ersten Datenverarbeitungsschaltung (72), der Zugang (b) mit dem Generator (70), der Zugang (c) mit der Verstärkerkette (74) und der Zugang (d) mit der Antenne (50) verbunden ist.

3. Vorrichtung nach Anspruch 2, dadurch gekennzeichnet, daß die Daten digitale sind.

4. Empfangsvorrichtung mit:
- einer ersten Antenne (90),
- einer zweiten Antenne (92),
- einem Umschalter (94), mit dem beliebig die erste oder die zweite Antenne in Betrieb genommen werden kann,
- einem Mikrowellengenerator (96), der abwechselnd eine erste Mikrowelle bei einer ersten Frequenz und eine zweite Mikrowelle bei einer zweiten Frequenz aussenden kann,
- einer Verstärker- und Erfassungskette (95), die bei einer Zwischenfreguenz arbeitet, die gleich dem Frequenzunterschied zwischen der ersten und der zweiten von dem Generator ausgesandten Welle ist,
- einer Verzögerungsschaltung (100), die mit der Kette (95) verbunden ist,
- eine Synchronisierungsschaltung (102), die den Generator (96), die Verzögerungsschaltung (100) und den Umschalter (94) steuert,
- Mitteln, um abwechselnd eine Modulationsfunktion bei der ersten Welle und eine Mischfunktion bei der zweiten Welle mit einer empfangenen Welle durchzuführen, die von einer der Antennen herkommt, und um eine Trennung zwischen der Sendewelle und der Empfangswelle sicherzustellen,
dadurch gekennzeichnet, daß diese Mittel von der Schaltung (40) gemäß Anspruch 1 gebildet sind, bei der der Zugang (a) mit der Verzögerungsschaltung (100), der Zugang (b) mit dem Generator (96), der Zugang (c) mit der Verstärkungs- und Erfassungskette (95) und der Zugang (d) mit dem Umschalter (94) verbunden ist.

5. Vorrichtung zur Lokalisierung eines Fahrzeuges in Bezug auf ein Funkfeuer dadurch gekennzeichnet, daß sich an Bord des Fahrzeugs (110) die Schaltung (40) gemäß Anspruch 1 befindet, wobei der Zugang (b) mit einem Generator (111) verbunden ist, der Zugang (c) mit einem Verstärker (112) verbunden ist, der mit einem Auslöser (113) verbunden ist, der mit einem monostabilen Multivibrator (114) verbunden ist, der auf den Zugang (a) rückgekoppelt ist, und daß der Zugang (d) mit einer Antenne verbunden ist und ein Funkfeuer die gleichen Elemente aufweist.

6. Vorrichtung zur Lokalisierung eines Fahrzeuges in Bezug auf ein Funkfeuer, dadurch gekennzeichnet, daß sich in Bord des Fahrzeuges die Schaltung (40) gemäß Anspruch 1 und Modulationsmittel für alles oder nichts befinden, wobei das Funkfeuer auch die Schaltung aufweist und als Beantworter arbeitet.

7. Empfangsvorrichtung, dadurch gekennzeichnet, daß sie die Schaltung gemäß Anspruch 1 aufweist, wobei zwischen die Zugänge (c) und (a) eine Kette eingefügt ist, die einen Verstärker, einen Auslöser, einen monostabilen Multivibrator umfaßt und daß die Vorrichtung einen mit dem Zugang (b) verbundenen Generator und eine mit dem Zugang (d) verbundene Sende-Empfangs-Antenne aufweist.

8. Fernmeßvorrichtung, dadurch gekennzeichnet, daß sie auf der Meßseite eine Schaltung (40) gemäß Anspruch 1 aufweist, wobei der Zugang (e) mit einem die Meßgröne erhaltenden, spannungsgesteuerten Oszilllator (132), der Zugang (b) mit einem Generator, der Zugang (d) mit einer Antenne (136) verbunden ist und auf der Empfängerseite eine Schaltung (40') gemäß Anspruch 1 vorgesehen ist, deren Zugang (d) mit einer Antenne (142), deren Zugang (b) mit einem Generator (134'), deren Zugang (c) mit einem Verstärker (144) verbunden ist, dem eine Phasensperrschleife (146) folgt, deren Ausgang eine der Mengröße (Va) entsprechende Größe (Va') abgibt.

## Claims

1. Microwave circuit carrying out the functions of a modulator, a mixer and a transmission-reception separator, including a 3dB directive coupler (42) having a first, a second, a third and a fourth port (b, d, b', d'), the first and second ports always being matched but the decoupling between these ports being large for a particular matching value of the impedances at the third and fourth ports, this circuit also including a first diode (44) connected to the third port (b') and a second diode (48) connected to the fourth port (d'), this circuit being characterized by the fact that the two diodes (44, 48) are connected in series through a first and a second capacitor (54, 56), and by the fact that it also includes:
   - one branch connected between a point located between the first diode (44) and the first capacitor (54) and a point located between the second capacitor (56) and the second diode (48), this branch including a first rejection inductor (52), a transistor (46) and a second rejection inductor (50), the transistor (46) having a base connected to a fifth port (a) which permits control of the conducting or cut-off state of the transistor,
   - a sixth port (c) connected to a point located between the two capacitors (54, 56),
   - a first line including at least one quarter wave element (58) connecting ground to a point located between the first diode (44) and the third port (b'),
   - a second line including at least one quarter wave element (60) connecting ground to a point located between the second diode (48) and the fourth port (d').

2. Transmitter-receiver device for bidirectional transmission, including:
   - a microwave generator (70) capable of alternately producing a transmission signal and a reception signal,
   - a first data-processing circuit (72) capable of receiving a continuous data train and of delivering this same data but grouped in blocks,
   - an amplification and detection system (74) working at an intermediate frequency equal to the difference in frequency between the transmission and reception signals,
   - a second data-processing circuit (76) connected to the said system (74) and capable of receiving data grouped in blocks and of delivering the same data in the form of a continuous train,
   - a synchronization circuit (78) controlling the first and the second data-processing circuits (72, 74) and the generator (70),
   - an antenna 80,
   - and means of alternately providing a modulation function of the transmission signal and a function of mixing a received signal with the reception signal, and of providing a separation between the transmission signal directed to the antenna and the received signal coming from the antenna, characterized in that these means are formed by the circuit (40) of Claim 1, in which the port (a) is connected to the first data-processing circuit (72), the port (b) is connected to the generator (70), the port (c) is connected to the amplification system (74) and the port (d) to the antenna (80).

3. Device according to Claim 2, characterized in that the data are of digital type.

4. Repeater device including :
   - a first antenna (90),
   - a second antenna (92),
   - a switcher (94) enabling either of the first and second antennas to be put into service,
   - a microwave generator (96) capable of alternately emitting a first microwave signal at a first frequency and a second microwave signal at a second frequency,
   - an amplification and detection system (98) working at an intermediate frequency equal to the difference in frequency between the first and second signals emitted by the generator,
   - a delay circuit (100) connected to the said system (98),
   - a synchronization circuit (102) controlling the generator (96); the delay circuit (100) and the switcher (94),
   - means of alternately providing a modulation function for the first signal and a function of mixing the second signal with a received signal coming from one of the antennas and to provide a separation between the transmission signal and the reception signal,
   characterized in that these means are formed by the circuit (40) of Claim 1, in which port (a) is connected to the delay circuit (100), port (b) is connected to the generator (96), port (c) is connected to the amplification and detection system (98), and port (d) to the, switcher (94).

5. Device for locating a moving object with respect to a beacon, characterized in that, on board the moving object (110) is found the circuit (40) according to Claim 1, port (b) being connected to a generator (111), port c to an amplifier (112) connected to a trigger (113) connected to a monostable (114) looped back to port a, port d being connected to an antenna, the beacon including the same elements.

6. Device for locating a moving object with respect to a beacon, characterized in that on board the moving object is found the circuit (40) according to Claim 1, and means of full or zero modulation, the beacon also including the said circuit and operating as a responder.

7. Repeater device, characterized in that it includes the circuit according to Claim 1, with, inserted between ports c and a system including an amplifier, a trigger and a monostable, and in that it includes a generator connected to port b and a transmission-reception antenna connected to port d.

8. Telemetry device, characterized in that it includes, on the measurement side, a circuit (40) according to Claim 1, port a being connected to a voltage-controlled oscillator (132) receiving the value to be measured, port b to a generator, port d to an antenna (136) and, on the reception side, a circuit (40') according to Claim 1, port d being connected to an antenna (142), port b to a generator (134'), port c to an amplifier (144) followed by a phase lock loop (146) whose output delivers a value (Va') corresponding to the measured value (Va).

# FIG.1

# FIG.2

# FIG.3

0 083 895

# FIG.4

# FIG.5

# FIG.6

FIG. 7

FIG. 8

FIG. 9